# FASCICULE DE BREVET EUROPEEN

(11) **EP 1 973 166 B1**
(45) Date de publication et mention de la délivrance du brevet: **09.09.2015**
(21) Numéro de dépôt: 08151943.1
(22) Date de dépôt: 26.02.2008
(51) Int. Cl.: H01L 27/144, H01L 31/0224, H01L 27/146

(54) **Circuit intégré photorécepteur, et composant optoélectronique comprenant le circuit intégré photorécepteur**
Integrierter Photorezeptorschaltkreis und diesen umfassende optoelektronische Komponente
Photoreceptor integrated circuit and optoelectronic component comprising the photoreceptor integrated circuit

(30) Priorité: 21.03.2007 CH 4512007
(43) Date de publication de la demande: 24.09.2008
(73) Titulaire: EM Microelectronic-Marin SA, 2074 Marin (CH)
(72) Inventeur: Quercia, Victorio, 1586 Vallamand (CH); Grandjean, André, 2088 Cressier (CH); Kayal, Abdul-Hamid, 2000 Neuchâtel (CH)
(74) Mandataire: Couillard, Yann Luc Raymond

(56) Documents cités:
- EP-A2- 1 536 478
- JP-A- 2000 332 228
- US-A- 5 865 935
- US-A1- 2004 095 501
- US-B1- 6 184 516

## Description

L'invention concerne un circuit intégré photorécepteur, qui comprend une région photosensible pour capter de la lumière et une région à unité de traitement pour traiter les signaux fournis par la région photosensible.

L'invention concerne également un composant optoélectronique, qui comprend le circuit intégré photorécepteur.

Un circuit intégré photorécepteur peut être réalisé généralement dans un substrat semi-conducteur en silicium. La région photosensible du circuit photorécepteur peut comprendre une matrice d'éléments photosensibles, tels que des photodiodes, ou une configuration particulière de plusieurs éléments photosensibles adjacents. L'unité de traitement du circuit photorécepteur permet de traiter les signaux fournis par les éléments de la région photosensible en tenant compte de la quantité de lumière captée par chaque élément photosensible.

Habituellement pour la réalisation d'un circuit photorécepteur, la région photosensible peut être entourée par des portions de à région à unité de traitement. Avec une telle répartition des deux régions du circuit photorécepteur, les plages de contact électrique dudit circuit photorécepteur sont généralement réparties tout autour de la région photosensible par exemple de manière uniforme, ce qui conduit à une perte de place. Cet agencement des plages de contact peut être prévu également en fonction d'une connexion électrique à des plages de connexion correspondantes d'un support traditionnel sur lequel le circuit photorécepteur peut être monté.

Certaines plages de contact du circuit photorécepteur monté sur le support ou une grille de connexion, sont reliées chacune par un fil métallique à une plage de connexion correspondante du support ou de la grille de connexion. Une fois la connexion électrique établie des plages de contact utilisées du circuit photorécepteur, une opération d'encapsulation permet de recouvrir au moins la région à unité de traitement, qui pourra être à l'abri de la lumière. Un passage de lumière est laissé par contre au-dessus de la région photosensible.

On peut citer la demande de brevet US 2004/0095501, qui décrit un dispositif d'imagerie. Le dispositif comprend un circuit photorécepteur muni d'une région photosensible et d'une région à unité de traitement. Des plages de contact sont réparties de manière symétrique sur toute la longueur de deux côtés opposés du circuit intégré. Le circuit intégré photorécepteur comprend des bosses métalliques sur les plages de contact de manière à être monté sur des plages de connexion d'un substrat flexible ayant un même arrangement que les bosses métalliques du circuit intégré. Pour le montage et la connexion électrique du circuit intégré sur le substrat flexible, il doit être appliqué une force de montage sur toute la surface au dos du circuit intégré. Cela peut induire des contraintes mécaniques de montage non souhaitées sur la région photosensible, ce qui constitue une inconvénient.

Dans la réalisation de circuits intégrés photorécepteurs de l'art antérieur comme indiqué ci-devant, aucune précaution n'est prise concernant l'emplacement des plages de contact et des régions du circuit photorécepteur pour permettre de réduire la taille dudit circuit. L'emplacement des plages de contact est en général prévu pour faciliter le montage sur un support ou une grille pour l'obtention d'un module ou composant optoélectronique traditionnel de dimension bien définie. Un tel module ou composant optoélectronique traditionnel peut prendre la forme par exemple d'un composant du type DIL ou SOIC. De ce fait, il n'est pas prévu d'optimiser la réalisation d'un circuit photorécepteur de manière à répondre aux exigences actuelles de réduction de taille de tout composant optoélectronique réalisé, ce qui est un inconvénient.

L'invention a donc pour but de fournir un circuit intégré photorécepteur, pour pallier tout inconvénient de l'art antérieur cité ci-devant, ayant un agencement particulier des différents éléments permettant notamment de réduire la taille du circuit photorécepteur réalisé et symétriser ou équilibrer certaines parties dudit circuit.

A cet effet, l'invention concerne un circuit intégré photorécepteur, qui comprend les caractéristiques mentionnées dans la revendication indépendante 1.

Des formes d'exécution spécifiques du circuit intégré photorécepteur sont définies dans les revendications dépendantes 2 à 9.

Un avantage d'un tel circuit intégré photorécepteur selon l'invention réside dans le fait que les plages de contact de tout le circuit sont disposées uniquement dans la région à unité de traitement en laissant libre la région photosensible. La région photosensible est juxtaposée à un côté de la région à unité de traitement pour définir deux régions distinctes dans un même substrat semi-conducteur, tel qu'en silicium.

Avantageusement, les plages de contact sont réparties de manière symétrique dans la région à unité de traitement par exemple selon deux rangées en périphérie disposées dans le sens de la longueur des deux régions juxtaposées. Un nombre égal de plages de contact à relier électriquement, qui sont régulièrement ou symétriquement espacées l'une de l'autre, peut être prévu dans chaque rangée.

Avantageusement, des bosses métalliques sont réalisées sur les plages de contact pour dépasser d'une couche de passivation du circuit intégré photorécepteur. Ces bosses métalliques, qui sont réparties de manière symétrique dans la région à unité de traitement, sont prévues pour être connectées directement sur des plages de connexion correspondantes d'un support ou substrat à circuit imprimé par une technique dénommée "flip chip" en terminologie anglaise. Pour ce faire, les plages de connexion du substrat ont un même arrangement et positionnement que les bosses métalliques. Grâce à cet agencement de bosses métalliques dans la région à unité de traitement, une force de montage du circuit sur le substrat n'est appliquée qu'au dos de la région à unité de traitement en laissant la région photosensible libre sans contraintes mécaniques de montage. La pression de contact due à la force de montage du circuit avec les bosses métalliques sur le substrat est ainsi répartie de manière adéquate ou d'une façon équilibrée. Un assemblage fiable est ainsi réalisé tout en laissant la partie photosensible du circuit intégré flottante.

L'invention a également pour but de fournir un composant optoélectronique, qui comprend un circuit intégré photorécepteur à taille réduite et à certaines parties symétrisées.

A cet effet, l'invention concerne un composant optoélectronique, qui comprend les caractéristiques mentionnées dans la revendication dépendante 7.

Des formes d'exécution spécifiques du composant optoélectronique sont définies dans les revendications dépendantes 8 et 9.

Un avantage du composant optoélectronique selon l'invention réside dans le fait qu'il comprend des plages de connexion sur un substrat à circuit imprimé pour une connexion à des plages de contact du circuit intégré photorécepteur disposées en regard de la région à unité de traitement dudit circuit. Ceci permet lors d'une opération de connexion électrique des plages de contact du circuit aux plages de connexion du substrat d'éviter tout contact mécanique avec la région photosensible laissée libre pour la protéger.

Avantageusement, le substrat du composant optoélectronique est un substrat flexible. Ce substrat flexible comprend une première portion sur laquelle est monté le circuit intégré photorécepteur, une seconde portion portant des bornes de connexion électrique du composant, et une troisième portion de liaison entre les première et seconde portions. Cette troisième portion porte des pistes conductrices reliant les bornes de connexion de la seconde portion aux plages de connexion de la première portion du substrat flexible.

Avantageusement, dans le cas où le circuit intégré photorécepteur comprend des bosses métalliques, la première portion du substrat flexible comprend des plages de connexion ayant un même arrangement et positionnement que les bosses métalliques. De cette façon, le circuit intégré photorécepteur peut être monté sur cette première portion par une technique dénommée "flip chip" en terminologie anglaise à l'aide d'une force appliquée uniquement au dos de la région à unité de traitement. Ceci permet grâce à l'agencement des bosses métalliques du circuit et de la première portion du substrat d'assurer un assemblage fiable du circuit sur le substrat.

Une ouverture traversante peut être ainsi prévue dans la première portion du substrat en regard uniquement de la région photosensible pour lui permettre de capter librement de la lumière. De préférence, uniquement la région à unité de traitement peut être encapsulée dans une résine ou sous un couvercle isolant électriquement et opaque à la lumière pour mettre cette région à l'abri de la lumière.

Les buts, avantages et caractéristiques du circuit intégré photorécepteur, ainsi que du composant optoélectronique le comprenant apparaîtront mieux dans la description suivante de formes d'exécution non limitatives illustrées par les dessins sur lesquels :
les figures 1a, 1b et 1c représentent une vue simplifiée tridimensionnelle de trois formes d'exécution du circuit intégré photorécepteur selon l'invention,
la figure 2 représente une vue en coupe partielle verticale d'une partie de la région à unité de traitement du circuit intégré photorécepteur selon l'invention,
la figure 3 représente une vue simplifiée tridimensionnelle d'une première forme d'exécution du composant optoélectronique selon l'invention, et
la figure 4 représente une vue simplifiée tridimensionnelle d'une seconde forme d'exécution du composant optoélectronique selon l'invention.

Dans la description suivante, toutes les parties du circuit intégré photorécepteur ou du composant optoélectronique qui sont bien connues d'un homme du métier dans ce domaine technique ne sont relatées que de manière simplifiée.

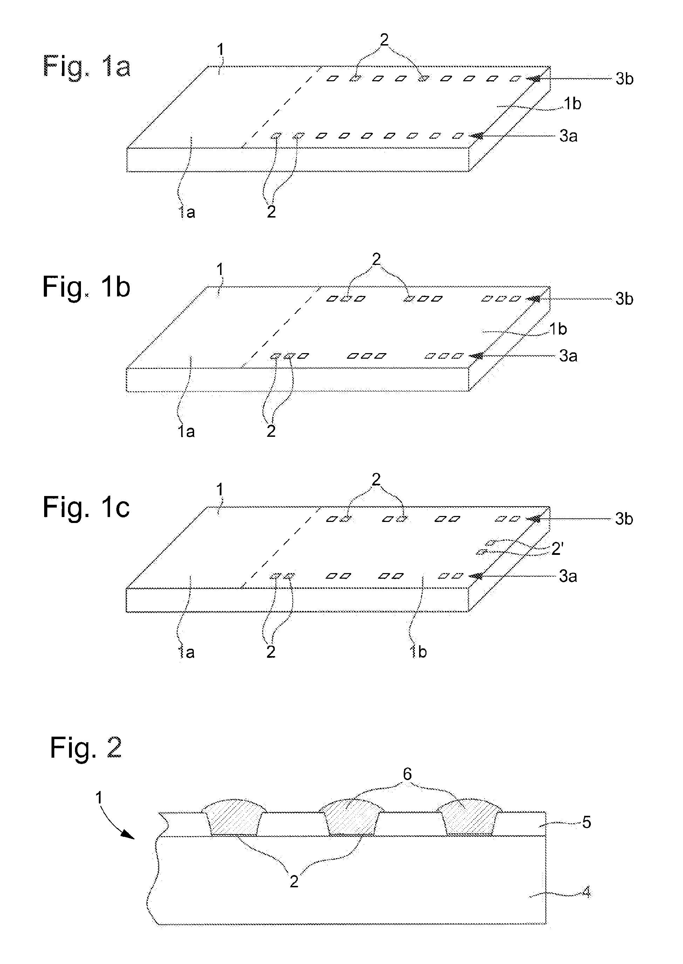

Aux figures 1a, 1b et 1c, le circuit intégré photorécepteur 1 est réalisé dans un substrat semi-conducteur, tel qu'un substrat en silicium. Il comprend notamment une région photosensible 1a, qui comprend plusieurs éléments photosensibles non représentés, tels que des photodiodes, et une région à unité de traitement 1 b pour traiter les signaux électriques fournis par les éléments de la région photosensible. La région photosensible 1a est directement juxtaposée à un côté de la région à unité de traitement 1 b comme montré par les traits interrompus aux figures 1a, 1b et 1c. De préférence, la surface de cette région photosensible 1 a peut être la moitié de la surface de la région à unité de traitement 1 b.

La région à unité de traitement 1 b comprend toutes les plages de contact 2, 2' du circuit photorécepteur selon l'invention, qui peuvent être reliées électriquement vers l'extérieur. Ces plages de contact peuvent être réparties de manière symétrique dans la région à unité de traitement. Les plages de contact 2 sont par exemple réparties selon deux rangées 3a et 3b en périphérie de deux côtés opposés de la région à unité de traitement 1 b dans le sens de la longueur des deux régions juxtaposées. Dans la figure 1c, il peut être prévu également des plages de contact 2' disposées en périphérie sur un côté de la région à unité de traitement, opposé au côté de liaison des deux régions. Bien entendu, toutes les plages de contact 2 et 2' sont réparties de manière symétrique par rapport à une ligne médiane dans le sens de la longueur du circuit intégré photorécepteur.

Le nombre de plages de contact 2 de chaque rangée est de préférence égal. Les plages de contact 2 de chaque rangée peuvent être régulièrement espacées sur toute la longueur de la région à unité de traitement 1 b comme montré à la figure 1a. II peut être prévu par exemple 18 plages de contact dont 9 plages de contact 2 par rangée 3a, 3b. La largeur de chaque plage de contact peut être de 100 µm, alors que l'espace entre chaque plage d'une même rangée peut être de 200 µm.

Bien entendu, d'autres configurations ou agencements desdites plages de contact peuvent être prévus dans la région à unité de traitement pour autant qu'elles soient réparties de manière symétrique dans ladite région 1 b. Elles peuvent par exemple être groupées par paquets régulièrement espacés de chaque côté opposé de la région à unité de traitement comme montré à la figure 1 b. Elles peuvent aussi être agencées en décalage l'une de l'autre sur les deux côtés de la région à unité de traitement 1 b. Cette symétrie de l'agencement des plages peut être nécessaire pour assurer un assemblage fiable du circuit photorécepteur sur un support à circuit imprimé par une technique dénommée "flip chip" en terminologie anglaise.

A la figure 1c, certaines plages de contact 2 sont réparties sur deux rangées 3a et 3b et groupées par paquets de deux plages de contact 2 par exemple, qui sont régulièrement espacés l'un de l'autre. D'autres plages de contact 2', par exemple deux plages de contact, peuvent être réparties sur le côté de la région à unité de traitement, opposé au côté de liaison des deux régions 1a et 1 b. Toutes les plages de contact 2, 2,' montrées dans cette figure 1c, sont réparties symétriquement par rapport à une ligne médiane dans le sens de la longueur du circuit intégré photorécepteur.

Pour un montage par la technique "flip chip", le circuit intégré photorécepteur 1 peut comprendre des bosses métalliques 6 réalisées sur les plages de contact 2 comme montré en figure 2. Les plages de contact 2 sont réalisées de manière traditionnelle sur le substrat semi-conducteur 4. Des ouvertures dans la couche de passivation finale 5 déposée sur le substrat 4 sont prévues pour donner accès à chaque plage de contact 2 du circuit intégré photorécepteur 1. Les bosses métalliques 6 sont donc réalisées à travers les ouvertures de la couche de passivation 5 depuis chaque plage de contact 2 pour dépasser de la surface supérieure de ladite couche de passivation.

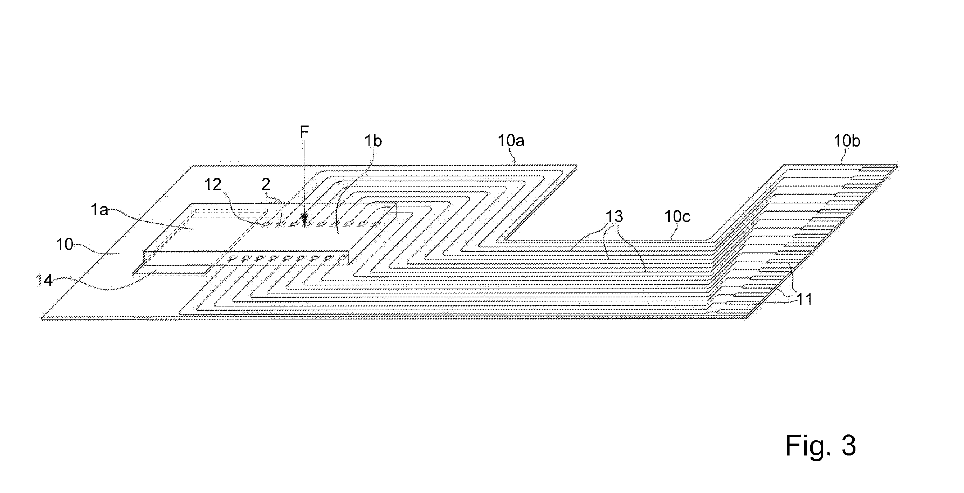

La figure 3 montre une vue tridimensionnelle d'une première forme d'exécution d'un composant optoélectronique. Ce composant optoélectronique comprend sur une première face d'un substrat 10, qui peut être de préférence flexible, un circuit intégré photorécepteur susceptible de capter de la lumière générée par exemple par une source de lumière non représentée. Le circuit photorécepteur comprend donc une région photosensible 1a et une région à unité de traitement 1 b selon la forme d'exécution décrite en référence à la figure 1 a par exemple.

Ce circuit photorécepteur est monté sur une première portion 10a du substrat flexible 10 par une technique "flip chip". Pour ce faire, des plages de contact 2 du circuit photorécepteur, qui comprennent des bosses métalliques comme montré à la figure 2, sont électriquement connectées sur des plages de connexion correspondantes 12 de la première portion du substrat 10. Les plages de connexion sont disposées selon un même arrangement et positionnement que les bosses métalliques de la région à unité de traitement 1 b du circuit selon deux rangées.

La connexion électrique entre les bosses métalliques et les plages de connexion du substrat 10 est effectuée par thermocompression ou à l'aide d'une colle anisotropique en appliquant une force F au dos de la région à unité de traitement 1 b du circuit photorécepteur. Grâce à l'agencement symétrique des plages de contact 2 avec les bosses métalliques du côté de la région à unité de traitement 1 b, la pression de contact due à la force F appliquée au dos du circuit photorécepteur est répartie uniformément sans contraintes mécaniques du côté de la région photosensible 1a. Cette région photosensible est donc laissée libre comme flottante sur un côté de la région à unité de traitement.

Le substrat flexible 10 comprend en plus de la première portion, une seconde portion terminale 10b, qui porte des bornes de connexion électrique 11, et une portion de liaison 10c entre les première et seconde portions 10a et 10b. Le substrat flexible 10 est sous la forme d'une feuille flexible dont l'épaisseur peut être de l'ordre de 75 µm. Des pistes conductrices 13, disposées sur une face ou l'autre de chaque portion du substrat flexible 10, permettent de relier certaines plages de connexion 12 aux bornes de connexion 11. Une ouverture traversante 14 est également prévue dans la première portion 10a en regard uniquement de la région photosensible 1a du circuit photorécepteur, étant donné que ledit circuit est monté par la technique "flip chip" sur ledit substrat. L'ouverture 14 permet à la région photosensible de capter de la lumière directement d'une source de lumière ou par réflexion sur une surface de travail.

Une encapsulation non représentée d'au moins la région à unité de traitement 1 b peut être prévue pour abriter cette région de la lumière et pour rigidifier la première portion du substrat flexible, tout en laissant libre et sans contraintes mécaniques la région photosensible 1a. Ceci permet de réaliser un composant optoélectronique de petite dimension. De plus grâce au substrat flexible avec une portion de liaison 10c, cela permet un ajustement de la seconde portion 10b de connexion électrique du composant par rapport à la première portion 10a portant le circuit photorécepteur.

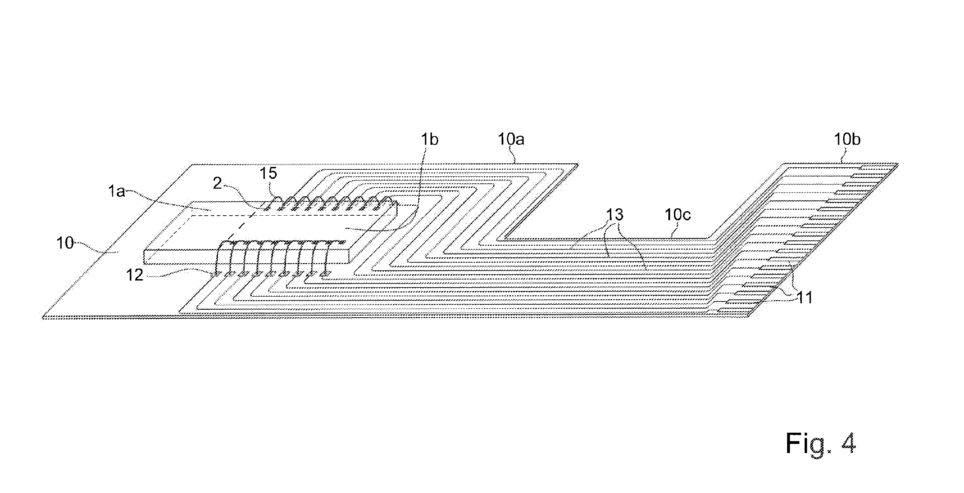

La figure 4 représente une vue tridimensionnelle d'une seconde forme d'exécution du composant optoélectronique. Ce composant optoélectronique comprend un circuit photorécepteur monté sur une première portion 10a d'un substrat flexible 10. Le circuit photorécepteur peut être de la forme d'exécution décrite en référence à la figure 1a par exemple. Ledit substrat comprend comme pour la première forme d'exécution, une seconde portion 10b, qui porte des bornes de connexion électrique 11, et une portion de liaison 10c entre les première et seconde portions. Le circuit photorécepteur comprend une région photosensible 1a et une région à unité de traitement 1 b.

A la différence de la première forme d'exécution, le dos du circuit photorécepteur est fixé sur une face de la première portion 10a du substrat flexible 10. La surface de réception de la région photosensible 1a est donc opposée à la face de fixation du circuit photorécepteur sur la première portion du substrat 10. De ce fait, il n'est pas prévu d'ouverture traversante dans cette première portion 10a.

La première portion 10a du substrat 10 comprend deux rangées de plages de connexion 12 disposées chacune de deux côtés opposés de la région à unité de traitement 1b uniquement. Ces plages de connexion 12 peuvent être arrangées de la même manière que les plages de contact 2 de la région à unité de traitement 1 b. La connexion électrique des plages de contact 2 est effectuée dans cette seconde forme d'exécution par des fils métalliques 15, tels que des fils en aluminium, aux plages de connexion correspondantes 12 de la première portion 10a du substrat 10. Ces plages de connexion 12 sont reliées à des pistes conductrices 13, de préférence métalliques, qui sont disposées sur une face ou l'autre du substrat. Les pistes conductrices relient ainsi les plages de connexion 12 aux bornes de connexion 11 placées sur la seconde portion 10b du substrat.

Comme précédemment, il peut être envisagé de n'encapsuler que la région photosensible, soit par de la résine, soit par un couvercle isolant opaque non représenté. Ceci permet de laisser libre la région photosensible 1 a sans contraintes mécaniques durant tout le procédé de réalisation du composant optoélectronique.

Un tel composant optoélectronique peut être utilisé dans tout type d'instrument électronique, tel qu'une souris d'ordinateur à fonctionnement optique. Dans ce cas, la première portion du substrat avec le circuit photorécepteur et éventuellement encore un circuit source de lumière, qui sont protégés par un couvercle, est montée sur un bloc transparent à lentille fixé sur une ouverture du fond du boîtier de la souris. Les bornes de connexion de la seconde portion du substrat sont reliées directement à une carte mère distante du fond du boîtier à l'intérieur de la souris.

Les plages de contact du circuit photorécepteur peuvent être agencées différemment, mais symétriquement dans la région à unité de traitement.

## Revendications

1. Circuit intégré photorécepteur (1) comprenant une région photosensible (1 a) avec plusieurs éléments photosensibles adjacents pour capter de la lumière et une région à unité de traitement (1 b) pour traiter les signaux fournis par les éléments photosensibles de la région photosensible, la région photosensible (1a) étant directement juxtaposée à un côté de liaison de la région à unité de traitement (1b),
des plages de contact électrique (2, 2') étant agencées uniquement dans la région à unité de traitement (1 b), de manière symétrique, et
au moins certaines plages de contact (2) étant réparties sur deux rangées (3a, 3b) en périphérie de deux côtés opposés de la région à unité de traitement (1b), et disposées dans le sens de la longueur des deux régions juxtaposées.

2. Circuit intégré photorécepteur (1) selon la revendication 1, **caractérisé en ce que** toutes les plages de contact (2) sont réparties sur les deux rangées en nombre égal dans chaque rangée (3a, 3b).

3. Circuit intégré photorécepteur (1) selon la revendication 1, **caractérisé en ce que** les plages de contact (2) de chaque rangée sont réparties uniformément et régulièrement espacées l'une de l'autre sur toute la longueur de chaque côté opposé de la région à unité de traitement (1 b).

4. Circuit intégré photorécepteur (1) selon la revendication 1, **caractérisé en ce que** les plages de contact (2) de chaque rangée sont groupées pour définir des paquets de plages de contact, qui sont répartis uniformément et régulièrement espacés l'un de l'autre sur toute la longueur de chaque côté opposé de la région à unité de traitement (1b).

5. Circuit intégré photorécepteur (1) selon la revendication 1, **caractérisé en ce que** des premières plages de contact (2) réparties sur les deux rangées (3a et 3b) sont groupées par paquets de plages de contact, qui sont régulièrement espacés l'un de l'autre, et **en ce que** des secondes plages de contact (2') sont disposées sur un côté de la région à unité de traitement, opposé à un côté de liaison des deux régions (1a, 1 b), les premières et secondes plages de contact étant réparties symétriquement par rapport à une ligne médiane dans le sens de la longueur du circuit intégré photorécepteur.

6. Circuit intégré photorécepteur (1) selon l'une des revendications précédentes, **caractérisé en ce que** des bosses métalliques (6) sont réalisées au-dessus des plages de contact (2, 2') du circuit photorécepteur pour dépasser d'une couche de passivation (5) sur le substrat semi-conducteur (4) du circuit photorécepteur.

7. Composant optoélectronique comprenant un circuit intégré photorécepteur (1) selon l'une des revendications précédentes, le composant comprenant un substrat flexible (10) à circuit imprimé sur lequel est monté et électriquement connecté le circuit intégré photorécepteur (1), **caractérisé en ce que** le circuit intégré photorécepteur comprend des bosses métalliques (6) sur les plages de contact (2, 2'), qui sont agencées pour être connectées directement, au moyen d'une force de montage du circuit intégré photorécepteur sur le substrat, qui est susceptible d'être appliquée uniquement au dos de la région à unité de traitement, à des plages de connexion électrique (12) d'une première portion (10a) du substrat (10) ayant un même arrangement et positionnement que les bosses métalliques (6) du circuit intégré photorécepteur.

8. Composant optoélectronique selon la revendication 7, **caractérisé en ce que** le substrat flexible (10) comprend une seconde portion (10b), qui porte des bornes de connexion électrique (11), et une portion de liaison (10c) entre les première et seconde portions (10a, 10b), des pistes conductrices (13), disposées sur une première face et/ou une seconde face de chaque portion du substrat flexible (10), permettant de relier certaines plages de connexion (12) aux bornes de connexion (11).

9. Composant optoélectronique selon la revendication 7, **caractérisé en ce qu'**une ouverture traversante (14) est prévue dans la première portion (10a) en regard uniquement de la région photosensible (1a) du circuit photorécepteur.

## Patentansprüche

1. Integrierte Photorezeptorschaltung (1), die eine photoempfindliche Region (1a) mit mehreren zueinander benachbarten photoempfindlichen Elementen, um Licht aufzufangen, und eine Region (1 b) mit Verarbeitungseinheit, um die von den photoempfindlichen Elementen der photoempfindlichen Region gelieferten Signale zu verarbeiten, umfasst, wobei die photoempfindliche Region (1a) direkt neben einer Verbindungsseite der Region (1 b) mit Verarbeitungseinheit angeordnet ist, wobei Bereiche (2, 2') für elektrischen Kontakt nur in der Region (1b) mit Verarbeitungseinheit symmetrisch angeordnet sind und wobei wenigstens bestimmte Kontaktbereiche (2) auf zwei Reihen (3a, 3b) am Umfang zweier gegenüberliegender Seiten der Region (1 b) mit Verarbeitungseinheit verteilt sind und in Längsrichtung der zwei nebeneinander angeordneten Regionen angeordnet sind.

2. Integrierte Photorezeptorschaltung (1) nach Anspruch 1, **dadurch gekennzeichnet, dass** alle Kontaktbereiche (2) auf die beiden Reihen mit gleicher Anzahl in jeder Reihe (3a, 3b) verteilt sind.

3. Integrierte Photorezeptorschaltung (1) nach Anspruch 1, **dadurch gekennzeichnet, dass** die Kontaktbereiche (2) jeder Reihe auf der gesamten Länge jeder gegenüberliegenden Seite der Region (1 b) mit Verarbeitungseinheit gleichmäßig verteilt und regelmäßig voneinander beabstandet sind.

4. Integrierte Photorezeptorschaltung (1) nach Anspruch 1, **dadurch gekennzeichnet, dass** die Kontaktbereiche (2) jeder Reihe gruppiert sind, um Kontaktbereichspakete zu definieren, die auf der gesamten Länge jeder gegenüberliegenden Seite der Region (1 b) mit Verarbeitungseinheit gleichmäßig verteilt und voneinander regelmäßig beabstandet sind.

5. Integrierte Photorezeptorschaltung (1) nach Anspruch 1, **dadurch gekennzeichnet, dass** erste Kontaktbereiche (2), die auf die beiden Reihen (3a und 3b) verteilt sind, durch Kontaktbereichspakete gruppiert sind, die regelmäßig voneinander beabstandet sind, und dass zweite Kontaktbereiche (2') auf einer Seite der Region mit Verarbeitungseinheit gegenüber einer Verbindungsseite der zwei Regionen (1a, 1b) angeordnet sind, wobei die ersten und die zweiten Kontaktbereiche in Bezug auf eine Medianlinie in Längsrichtung der integrierten Photorezeptorschaltung symmetrisch verteilt sind.

6. Integrierte Photorezeptorschaltung (1) nach einem der vorhergehenden Ansprüche, **dadurch gekennzeichnet, dass** Metallhöcker (6) auf den Kontaktbereichen (2, 2') der Photorezeptorschaltung verwirklicht sind, um eine Passivierungsschicht (5) auf dem Halbleitersubstrat (4) der Photorezeptor-schaltung zu überragen.

7. Optoelektronische Komponente, die eine integrierte Photorezeptorschaltung (1) nach einem der vorhergehenden Ansprüche umfasst, wobei die Komponente ein flexibles Substrat (10) mit gedruckter Schaltung umfasst, auf dem die integrierte Photorezeptorschaltung (1) montiert und elektrisch angeschlossen ist, **dadurch gekennzeichnet, dass** die integrierte Photorezeptorschaltung Metallhöcker (6) auf den Kontaktbereichen (2, 2') aufweist, die dafür ausgelegt sind, direkt mittels einer Montagekraft der integrierten Photorezeptorschaltung auf dem Substrat, die nur auf die Rückseite des Bereichs mit Verarbeitungseinheit ausgeübt werden kann, mit Bereichen (12) für elektrischen Anschluss eines ersten Abschnitts (10a) des Substrats (10), die dieselbe Anordnung und Positionierung wie die Metallhöcker (6) der integrierten Photorezeptorschaltung haben, verbunden zu werden.

8. Optoelektronische Komponente nach Anspruch 7, **dadurch gekennzeichnet, dass** das flexible Substrat (10) einen zweiten Abschnitt (10b) umfasst, der elektrische Verbindungsanschlüsse (11) trägt, und einen Verbindungsabschnitt (10c) zwischen dem ersten und dem zweiten Abschnitt (10a, 10b) umfasst, wobei leitende Bahnen (13), die auf einer ersten Fläche und/oder einer zweiten Fläche jedes Abschnitts des flexiblen Substrats (10) angeordnet sind, ermöglichen, bestimmte Anschlussbereiche (12) mit den Verbindungsanschlüssen (11) zu verbinden.

9. Optoelektronische Komponente nach Anspruch 7, **dadurch gekennzeichnet, dass** eine Durchgangsöffnung (14) in dem ersten Abschnitt (10a) nur gegenüber der photoempfindlichen Region (1a) der Photorezeptorschaltung vorgesehen ist.

## Claims

1. Integrated photoreceptor circuit (1) including a photosensitive area (1a) with several adjacent photosensitive elements for picking up light and a processing unit area (1 b) for processing the signals supplied by the photosensitive elements of the photosensitive area, electric contact pads (2, 2') being arranged solely on the side of the processing unit area (1 b), which is juxtaposed with the photosensitive area (1 a), **characterized in that** the contact pads are arranged symmetrically in the processing unit area, and **in that** at least some contact pads (2) are distributed in two rows (3a, 3b) at the periphery of the two opposite sides of the processing unit area (1 b), arranged along the length of the two juxtaposed areas.

2. Integrated photoreceptor circuit (1) according to claim 1, **characterized in that** all of the contact pads (2) are distributed in the two rows in equal numbers in each row (3a, 3b).

3. Integrated photoreceptor circuit (1) according to claim 1, **characterized in that** the contact pads (2) of each row are uniformly distributed and regularly spaced from each other over the entire length of each opposite side of the processing unit area (1 b).

4. Integrated photoreceptor circuit (1) according to claim 1, **characterized in that** the contact pads (2) of each row are grouped to define packets of contact pads, which are uniformly distributed and regularly spaced from each other over the entire length of each opposite side of the processing unit area (1 b).

5. Integrated photoreceptor circuit (1) according to claim 1, **characterized in that** first contact pads (2) distributed in the two rows (3a and 3b) are grouped in packets of contact pads, which are regularly spaced from each other, and **in that** second contact pads (2') are arranged on one side of the processing unit area, opposite a side connecting the two areas (1 a, 1 b), the first and second contact pads being symmetrically distributed relative to a median line along the length of the integrated photoreceptor circuit.

6. Integrated photoreceptor circuit (1) according to any of the preceding claims, **characterized in that** metal bumps (6) are made above the contact pads (2, 2') of the photoreceptor circuit to project from a passivation layer (5) on the semiconductor substrate (4) of the photoreceptor circuit (4).

7. Optoelectronic component including an integrated photoreceptor circuit (1) according to any of the preceding claims, the component including a flexible printed circuit substrate (10) on which the photoreceptor circuit (1) is mounted and electrically connected, **characterized in that** the integrated photoreceptor circuit includes metal bumps (6) on the contact pads (2, 2'), which are connected, by means of an assembly force of the circuit on the substrate, applied solely to the back of the processing unit area, to electrical connection pads (12) of a first portion (10a) of said substrate (10) having the same arrangement and position as the metal bumps (6) of the integrated photoreceptor circuit.

8. Optoelectronic component according to claim 7, **characterized in that** the flexible substrate (10) includes a second portion (10b), which carries electrical connection terminals (11), and a connecting portion (10c) between the first and second portions (10a, 10b), conductive paths (13) arranged on a first face and/or a second face of each portion of the flexible substrate (10), connecting certain connection pads (12) to the connection terminals (11).

9. Optoelectronic component according to claim 7, **characterized in that** a through aperture (14) is provided in the first portion (10a) opposite the photosensitive area (1 b) only of the photoreceptor circuit.
